# EUROPEAN PATENT APPLICATION

(11) **EP 2 315 255 A1**
(43) Date of publication of application: **27.04.2011**
(21) Application number: 09173797.3
(22) Date of filing: 22.10.2009
(51) Int. Cl.: H01L 29/87, H01L 29/872, H01L 23/495

(54) **Surge protection device**

(71) Applicant: NXP B.V., 5656 AG Eindhoven (NL)
(72) Inventor: Holland, Steffen, Redhill, Surrey RH1 1DL (GB)
(74) Representative: Williamson, Paul Lewis

(57) **Abstract**

Disclosed is a surge protection device (200) comprising a semiconductor substrate (210) of a first conductivity type, said semiconductor substrate having a first surface and a second surface opposite to the first surface, the substrate further comprising a first junction device at the first surface having a junction oriented parallel to the first surface, and a second junction device at the second surface having a junction oriented parallel to the second surface, said first and second junction devices facing each other, with the first and second junction being separated by the bulk of the semiconductor substrate.

## Description

### FIELD OF THE INVENTION

The present invention relates to a surge protection device comprising a semiconductor substrate of a first conductivity type, said semiconductor substrate having a first surface and a second surface opposite to the first surface, the substrate further comprising a first junction device at the first surface having a junction oriented parallel to the first surface.

### BACKGROUND OF THE INVENTION

A common cause of damage to electronic devices is the exposure of such devices to electrical overstress or electrostatic discharge pulses. For this reason, packages that include such electronic devices are usually fitted with one or more surge protection devices that protect the electronic device from exposure to such pulses.

Such a surge protection device must be capable of consuming the full spike in the power supply, but must not interfere with the normal functioning of the electronic device. For instance, for electronic devices comprising data lines, it is important that the surge protection device has a small as possible capacitance to ensure that a sufficiently data transfer rate over the data lines can be achieved.

Typically, surge protection devices have to be able to cope with surges in the power supply having an extended duration. There are several standards in existence that mandate the required behavior of the surge protection device in terms of pulse duration. For instance, the IEC 61000-4-5 and IEC 61643-321 standards dictate that the surge protection devices respectively have to be able to cope with so-called 8/20 and 10/1000 pulses on data or power lines. In order to achieve the required behavior, the surge protection devices typically short the data or power lines to ground during the occurrence of such a pulse. Ideally, the surge protection devices are capable of handling high currents at low clamping voltages in addition to the aforementioned low capacitance.

Discrete ESD protection devices typically comprise one or more p-n junction devices such as diodes implanted, i.e. diffused, into a surface to provide a I ow-ohmic connection between positive and negative lead frames of a semiconductor device package. Such p-n junction devices may be series-connected to lower the capacitance of the protection device.

Different types of junction devices may be considered. For instance, unidirectional surge protection devices tend to utilize Schottky diodes or p-n junction diodes. The robustness of the surge protection device typically scales with the active area of the diode, whereas the heat conductivity may be improved by placement of a metal clip on the surface of the surge protection device. The backside of the surge protection device is typically mounted on one of the lead frames using a metal or a solder to establish a conductive connection.

Bidirectionality in the surge protection between lead frames is typically achieved by using multiple junction devices, either on discrete substrates or implanted into the surface of a single substrate in a laterally displaced fashion. Stacks of substrates have also been used. The specific implementation may depend on the type of surge pulse against which protection is to be provided.

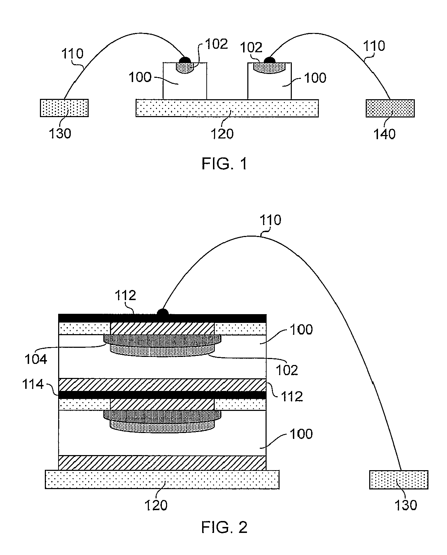

FIG.1 depicts a prior art arrangement for protection against 8/20 pulses having two surge protection devices 100 mounted on a lead frame 120, the surge protection devices 100 being connected to further lead frames 130, 140 via respective bond wires 110. Each surge protection device consists of a p-type silicon substrate having an n-type impurity 102 connected to the bond wire 110. Such an arrangement may be used for protection against 8/20 pulses. As can be seen in FIG. 1, the surge protection device 100 that has the smaller n-type impurity region 102 acts as a small diode in forward bias. Its main role is to reduce the capacitance of the overall surge protection structure. The surge protection device 100 having the larger n-type impurity region 102, i.e. having a larger diode, is reverse biased and can withstand the energy of the surge pulse.
FIG. 2 depicts another prior art arrangement, in which two surge protection devices 100 are stacked on top of a lead frame 120 with the top substrate being connected to a further lead frame 130 through a bond wire 110. Each surge protection device comprises metal connections 112, a p-n junction formed by respective implanted regions 102 and 104 of opposite conductivity type, with the surge protection devices 100 being separated from each other by a conductive interlayer 114.

For many applications, either large and/or multiple surge protection devices are required to provide a satisfactory surge protection to ensure that the surge protection device(s) can consume the full current generated during an ESD or electrical overstress event. This can be costly, and may require that large areas of an apparatus requiring surge protection are dedicated to such surge protection devices.

### SUMMARY OF THE INVENTION

The present invention seeks to provide a surge protection device having an improved robustness to current surges.

In accordance with an aspect of the present invention, there is provided a surge protection device according to claim 1.

The provision of a junction device on opposite surfaces of the semiconductor substrate that each generate a substantial part of the electrical field upon exposure to a surge pulse, the surge robustness per unit size of the substrate is improved. This translates to the ability of the substrate to absorb larger current surges compared to prior art surge protection devices, thus reducing the required area of the surge protection device and/or the number of surge protection devices required. In addition, this ensures that the device comprises two distinct hot spots around the respective junctions, thus reducing the risk of damage to the device caused by local heating upon exposure to a surge pulse.

Suitable junction devices include p-n junction diodes, Schottky diodes, transistors, thyristors and combinations thereof. The term junction device is intended to include all semiconductor devices in which at least one junction is present as a (potential) barrier between (semi-)conducting structures of the device. The respective junction devices on the opposite surfaces of the surge protection device of the present invention may be of the same type or may be different types of junction devices.

Suitable semiconductor substrate materials include but are not limited to silicon substrates. In the context of the present invention, it is preferable that the semiconductor substrate is a crystalline material although amorphous materials may also be used.

Preferably, the first and second junction devices are designed such that, upon exposure of the surge protection device to a surge pulse, said junction devices generate an electric field that is distributed from the first surface to the second surface. Preferably, the junction devices are arranged such that each device generates about half of the total electrical field. This has the advantage that the heat distribution through the semiconductor substrate is substantially homogeneously distributed over a large volume of the substrate, thus further improving the surge robustness per unit substrate size.

In order to improve the heat transport out of the semiconductor substrate, at least one of the first surface and second surface may carry a metal connection to the corresponding junction device, wherein said metal has a heat conductivity exceeding a predefined threshold. This may for instance be a metal structure soldered onto the semiconductor substrate, which may be brought into contact with a metal clip to further improve heat conductivity.

In an embodiment, the surge protection device further comprises a first further junction device at the first surface having a junction oriented parallel to the first surface, said first further junction device being laterally displaced to the first junction device; and a second further junction device at the second surface having a junction oriented parallel to the second surface, said second further junction device being laterally displaced to the second junction device. The provision of multiple pairs of junction devices on opposite surfaces of the semiconductor substrate further improves the robustness of the surge protection device against current surges and thus facilitates a further reduction of the area required for the surge protection devices in an apparatus requiring surge protection.

The surge protection device of the present invention may be integrated in an apparatus requiring such protection. In an embodiment, the apparatus comprises a first lead frame and a second lead frame, wherein the second surface of the surge protection device is mounted onto the second lead frame such that the second junction device is directly connected to the second lead frame and wherein the first junction device is electrically connected to the first lead frame through a bond wire. Thus, a surge protection arrangement comprising two junction devices but requiring only a single bond wire is provided.

The apparatus comprise more than two lead frames. For instance, in case of the presence of a third lead frame, the surge protection device may further comprise a first further junction device laterally displaced with respect to the first junction device, said first further junction device being electrically connected to the third lead frame through a further bond wire. Alternatively, the surge protection device may further comprise a second further junction device laterally displaced with respect to the second junction device, said second further junction device being directly connected to the third lead frame. These arrangements provide a more compact surge protection compared to prior art solutions in which multiple substrates had to be used in order to achieve the same level of surge protection.

### BRIEF DESCRIPTION OF THE EMBODIMENTS

Embodiments of the invention are described in more detail and by way of non-limiting examples with reference to the accompanying drawings, wherein:
FIG. 1 and 2 schematically depict prior art surge protection arrangements;
FIG. 3 schematically depicts a non-limiting example of a surge protection device in accordance with an embodiment of the present invention;
FIG. 4 depicts a doping profile along the line A-A' in FIG. 3;
FIG. 5 and 6 schematically depict further non-limiting examples of a surge protection device in accordance with an embodiment of the present invention;
FIG. 7 depicts a comparison of the doping profile and associated thermal behavior of a prior art surge protection device and a surge protection device in accordance with an embodiment of the present invention;
FIG. 8 and 9 show yet further non-limiting examples of a surge protection device in accordance with an embodiment of the present invention;
FIG. 10 depicts a doping profile along the line A-A' in FIG. 9; and
FIG. 11-13 schematically depict examples of a surge protection device of the present invention integrated into an apparatus.

### DETAILED DESCRIPTION OF THE DRAWINGS

It should be understood that the Figures are merely schematic and are not drawn to scale. It should also be understood that the same reference numerals are used throughout the Figures to indicate the same or similar parts.

For the sake of brevity, the present invention will now be described in more detail using silicon as a non-limiting example of a suitable semiconductor substrate material. It should however be understood that the proposed solution is valid for any semiconductor material.

Common causes for failure of a surge protection device include local overheating of the semiconductor substrate or degradation of the metal contacts on the semiconductor substrate upon exposure to a current surge. This is mostly caused by a sudden confinement of the current flow to a relatively small region of the active area of the surge protection device. This phenomenon is generally known as second breakdown. The resulting heat causes the silicon to melt directly at or near a p-n junction or causes the degradation of a metal contact. This leads to leakage currents or even ohmic behaviour when metal from the contacts shorts the junction.

Local heat generation can be described by the vector product of electric field and current density *D̅·J̅*. This causes the diffusion of heat into the surrounding material. The (current) pulse type, or more specifically, its duration determines the magnitude of the heat diffusion. The longer the pulse the more important (extensive) the heat diffusion becomes. Typically, a large ratio of the total electric field strength is reduced at a p-n junction in blocking mode. Such a p-n junction may be a part of a p-n junction diode, or may be part of other suitable junction devices such as a transistor or a thyristor. In the following, the area in which the heat is generated will be referred as 'hotspot'.

The robustness of a surge protection device can be increased by avoiding local overheating. Two main principles are available to achieve this. Firstly, the generated heat should be transported away as efficiently as possible and secondly, the heat generation itself has to be spread over a large as possible volume. How large the volume has to be depends on the length or duration of the pulse, i.e. the distance the heat can diffuse during one pulse. The nature of the pulse also has an impact on this. For ESD pulses, the shape of the electric field around the p-n junction also has an impact as the heat diffusion length is of the order of the electric field distribution. For 10/1000 pulses, the heat diffusion length is much larger than the depletion region of the p-n junction such that in this case the electric field distribution can be neglected.

In the latter case, it is preferably to create at least two distinct hot spots that have been separated from each other by the largest possible extent. The present invention has been at least partially based on the realization that for a given semiconductor substrate with optimized active area and a vertical current flow, sufficient surge protection behaviour may be obtained when the hot spots are placed at opposite surfaces of the substrate, i.e. at the front and back side rather than on different substrates or on the same surface of a single substrate having a much larger footprint. Hence, effective surge protection is obtained at a reduced cost because less substrate volume is required.

Efficient heat transport away from these hotspots may be facilitated by providing respective metal contacts to the hotspots on the surfaces of the semiconductor substrate. A non-limiting example of a metal having sufficiently high heat conductivity is copper and its alloys.

In the following, a number of surge protection devices in accordance with the present invention will be described by way of non-limiting example only. It should be understood that in accordance with the present invention, the opposite surfaces of the semiconductor substrate each may contain any type and any number of junction devices as long as each surface comprises at least one such junction device. Depending on the required functional behavior of the surge protection device, e.g. unidirectional, bidirectional and so on, the same or different types of junction devices may be provided on the opposite surfaces.

In the case of the junction devices being p-n junction devices, the surge protection devices may be implemented by means of first and second impurity regions of opposite conductivity types diffused into the first surface, i.e. p-type and n-type impurities. The first region may be embedded in the second region or vice versa. The junction devices at opposite surfaces are vertically separated from each other by the bulk of the semiconductor substrate, with, in a favorable embodiment, the thickness of the bulk exceeding the thickness of any of the diffusion regions by at least a factor two, preferably at least a factor five. The bulk material may be an n-type or p-type material.

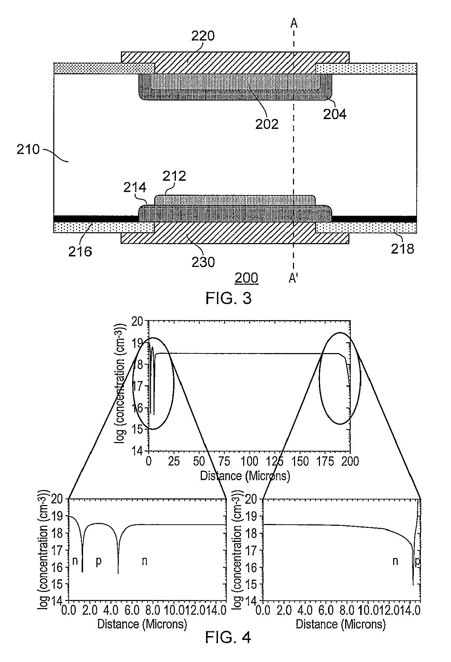

FIG. 3 shows an example of a unidirectional surge protection device 200 in accordance with an embodiment of the present invention, in which a bipolar transistor and a p-n diode are used as junction devices. The bipolar transistor has an emitter 202 embedded in a base 204, with the impurity diffusion regions 212 and 214 forming the p-n diode. In an embodiment, the bulk 210 of the semiconductor substrate is an n-type material, as are the impurity diffusion regions 202 and 212, with the impurity diffusion regions 204 and 214 being of a p-type. The bulk 210 acts as the collector of the bipolar transistor. Obviously, an alternative embodiment in which these regions are chosen to be of opposite conductivity type is equally feasible.

In FIG. 3, the n-doped impurity region 212 may be formed by the formation of an n-type epitaxial layer 216 and implanting a high concentration of an n-type impurity into this layer. It is however pointed out that the diffusion regions in the surge protection device 200 may be formed in any suitable manner. Since the formation of diffusion regions in a semiconductor substrate such as a silicon die is a matter of routine skill for the skilled person, the formation of such diffusion regions will not be further explained for reasons of brevity only. Any suitable n-type and p-type impurity may be used.

Metallic contacts 220 and 230, e.g. Cu contacts, are provided to facilitate heat transport away from the hotspots defined by the junction devices. In addition, the top contact 220 may be connected to a bond wire (not shown), e.g. by soldering, for connection a lead frame (not shown). The bottom contact 230 may be directed mounted, e.g. by soldering, onto another lead frame (not shown). This will be explained in further detail later.

FIG. 4 shows the doping profile of the surge protection device 200 of FIG. 3 along the cross-section A-A'. In this embodiment, the doping profile is chosen such that the breakdown voltage of the diode as well as the open base transistor breakdown voltage BVCEO is approximately 10 V, such that half of the electric field drops in the vicinity of the top surface of the substrate and the rest at the other surface to obtain an even heat distribution throughout the substrate, as previously explained.

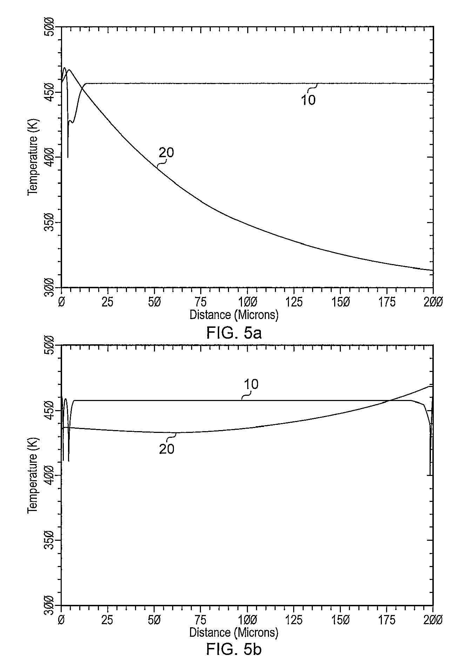

This is shown in more detail in FIG. 5, in which the doping profiles (lines 10) and simulated temperature profiles (lines 20) in response to exposure to a 10/1000 pulse along the line A-A' for a prior art unidirectional device having two silicon substrates each having a single p-n junction structure in the top surface (graph a) and the unidirectional device of FIG. 3 (panel b) are shown. It is immediately apparent that the unidirectional surge protection device of the present invention exhibits a much more homogeneous temperature distribution when exposed to a 10/1000 pulse, thus greatly reducing the risk of local overheating of the silicon substrate.

It is pointed out for the sake of clarity that the temperature profiles in FIG. 5 of the prior art device is the result of exposure to a much weaker surge pulse compared to the surge protection device of the present invention. The strength of the applied surge pulses has been summarized in Table I. It is further noted that exposure of the surge protection device of the present invention to the same strength surge pulse as used for the prior art device would lead to the generation of a substantially homogeneous temperature profile through the semiconductor substrate at a substantially lower maximum temperature compared to the prior art surge protection device.

Further simulation results have been summarized in Table I.

**Table I**

| | breakdown voltage (V) | Maximum pulse current (A) |
|---|---|---|
| single diode device | 20 | 16.5 |
| Device 200 (FIG. 3) | 21 | 31 |

As can be seen from Table I, the surge protection device 200 of the present invention achieves an improvement in surge robustness of 87% (i.e. 31.5/16^{*}100%) in comparison to a standard protection diode with similar breakdown voltage. Verification of these simulation results by measurement showed an improvement of the surge robustness of the surge protection device 200 compared to a single diode prior art device of 38%.

The difference between measurement and simulation is most likely caused by a non-optimal choice of process parameters, i.e. the breakdown voltages of the bipolar transistor and diode forming the respective junction devices were not equal. In addition, instead of a copper metallization at the top and back surfaces of the silicon substrate, a standard solder assembly technology (SOD123W) was used, thus reducing heat-transfer capability and increasing ohmic resistance, especially since the solder coverage was not optimal.

For the sake of completeness, it is pointed out that the surge protection device 200 of FIG. 3 is not a 'true' unidirectional device, as will be understood by the skilled person. This is because the bipolar transistor at the upper surface blocks in both current flow directions. However, for surge protection applications including ESD protection, the voltage drop in forward direction is of limited importance. In fact, by appropriate tuning of the impurity concentrations of the diffusions 202, 204, the forward direction blocking voltage may be reduced to only a few volt such that that the bipolar transistor will approach the forward voltage drop of a p-n junction diode at high currents.

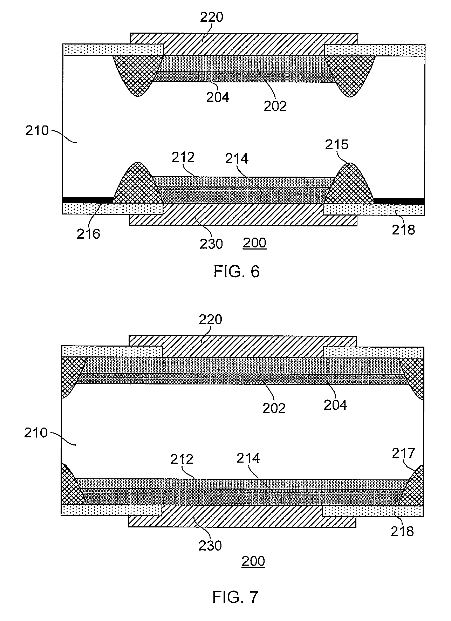

Also, in FIG. 3, the junction devices of the surge protection device are laterally terminated by means of planar technology by way of non-limiting example only. FIG. 6 and 7 show two embodiments in which the junction devices are laterally terminated using a mesa technology, as demonstrated by end portions 215 and 217 respectively.

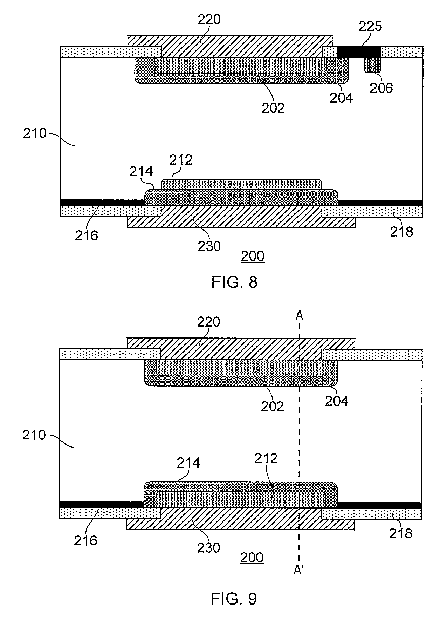

An alternative embodiment of the unidirectional surge protection device in FIG. 3 is shown in FIG. 8, in which an additional metal contact 225 between the base 204 and a collector contact 206 is provided. For low currents, the additional metal contact 225 acts as a short of the base-collector junction and the emitter-base junction as well as the p-n junction diode at the bottom surface of the substrate behave as two diodes in series. At increased currents, series resistances will cause an increase of voltage drop until the transistor forward voltage limit is reached, causing the transistor to turn on, such that a vertical current flows over the whole width of the device. It is pointed out that in the embodiment of FIG. 8, the impurity region 212 is provided for controlling the breakdown of the surge protection device 200 and may be omitted.

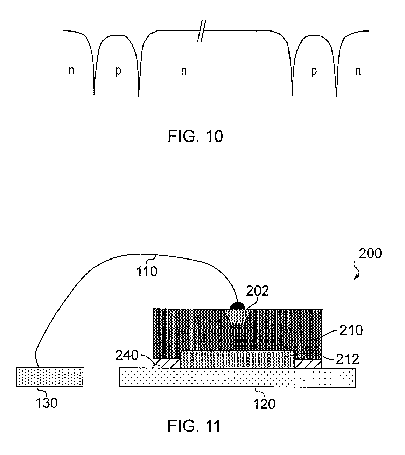

FIG. 9 shows a non-limiting example of a bidirectional surge-protection device 200 of the present invention, in which the top and bottom surface of the silicon substrate each carry a p-n junction diode such that a p-n-p-n-p or n-p-n-p-n doping profile is achieved along the line A-A'. An example of a suitable embodiment of the latter doping profile is shown in FIG. 10. As will be recognized by the skilled person, the bidirectional surge protection device 200 in FIG. 9 is realized by the provision of two bidirectional transistors as junction devices in the opposite surfaces of the semiconductor substrate 210. In the example shown in FIG. 9, the top transistor is formed by an n-type emitter 202 embedded in a p-type base and the bottom transistor is formed by an n-type emitter 212 embedded in a p-type base 214. The bulk of the semiconductor substrate 210 acts as the collector for both transistors. Again, the alternative embodiment in which the impurities of these regions are of opposite conductivity type is equally feasible.

Although the above examples show surge protection devices 200 in which a single junction device only is implanted into each surface, it should be understood that embodiments in which each surface incorporates multiple junction devices is equally feasible. Moreover, the top surface may carry a different number of junction devices than the bottom surface, as will also be shown below.

The surge protection device 200 of the present invention may be integrated in an apparatus requiring surge protection in any suitable manner. It is pointed out that the arrangement of junction devices in opposite surfaces of the surge protection device 200 of the present invention facilitates a number of advantages over prior art integrations. In particular where prior art solutions required the use of multiple substrates for the integration of adequate surge protection, the present invention facilitates a reduced footprint of the substrates, such that a protection device with the same performance can be offered in a smaller package with since fewer bond wires, the apparatus can be realized at lower cost. In addition, since the lead frame itself acts as a clip for the bottom junction device, a better heat transport away from the junction, e.g. a p-n junction or Schottky barrier, can be achieved. For an apparatus requiring multiple surge protection devices, the surge protection device 200 may be used in conjunction with prior art surge protection devices without departing of the teachings of the present invention.

FIG. 11 depicts a non-limiting example of an apparatus of the present invention, in which a surge protection device 200 is placed on a lead frame 120 such that a large n-type diffusion region 212 in the p-type substrate is brought into conductive contact with the lead frame 120. Such a contact may be optionally achieved through a metal contact such as the metal contact 230 shown in FIG. 3. The n-type diffusion region 212 may be laterally bordered by an insulating material 240, e.g. a silicon oxide. The smaller n-type diffusion region 202 in the top surface of the p-type substrate is connected through a bond wire 110 to a further lead frame 130. Such an arrangement can for instance be used to protect the apparatus against 8/20 pulses.

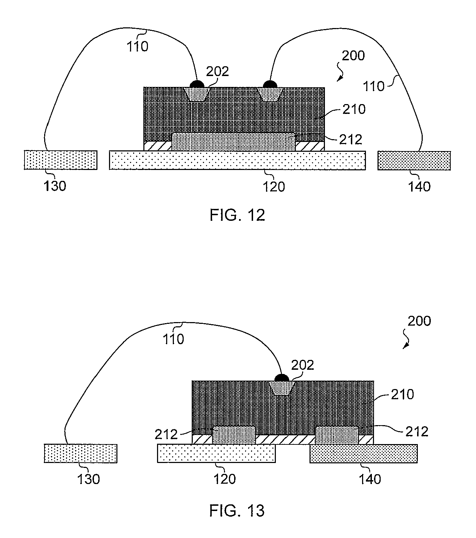

As previously stated, the front and/or the back surface of the semiconductor substrate may have more than one (p-n) junction area. An example of such a configuration is shown in FIG. 12, which depicts a multichannel unidirectional protection device 200 formed by a p-type substrate 210 with two laterally separated n-type impurity regions 202 in the top surface and a single n-type impurity region 212 in the bottom surface. The n-type impurity regions 202 are connected to lead frames 130, 140 via respective bond wires 110, with the n-type impurity region 212 brought into direct contact with the lead frame 120 as previously explained. Metal contacts similar to metal contacts 220 and 230 as shown in FIG. 3 may be added to each impurity region to improve the heat conductivity of the corresponding junction device as previously explained.

FIG. 13 shows an embodiment in which the bottom surface of the semiconductor substrate 210 comprises multiple junction devices, i.e. p-n diodes formed by the n-type impurity regions 212 and the bulk of the p-type semiconductor substrate 210. The n-type impurity regions 212 are directly mounted onto respective lead frames 120 and 140, preferably via metal contacts as previously explained and the top surface n-type impurity region 202 is connected to further lead frame 130 via a bond wire 110.

It is noted that the respective junction devices in FIG. 11-13 have different capacitances to ensure that adequate surge protection is provided without negatively affecting switching speeds on e.g. data lines of a device protected by the surge protection device 200.

Obviously, the conductivity types of the surge protection devices shown in FIG. 11-13 may be inverted without departing from the teachings of the present invention. Furthermore, many other ways of realizing the present invention are readily available. Instead of p-n junction diodes, other devices such as transistors, Schottky diodes could be used. A combination of different devices to form a complex junction device is also possible. Instead of a p-n junction diode at the bottom surface of the surge protection device 200, an open base transistor or a thyristor may also be used.

It should be noted that the above-mentioned embodiments illustrate rather than limit the invention, and that those skilled in the art will be able to design many alternative embodiments without departing from the scope of the appended claims. In the claims, any reference signs placed between parentheses shall not be construed as limiting the claim. The word "comprising" does not exclude the presence of elements or steps other than those listed in a claim. The word "a" or "an" preceding an element does not exclude the presence of a plurality of such elements. The invention can be implemented by means of hardware comprising several distinct elements. In the device claim enumerating several means, several of these means can be embodied by one and the same item of hardware. The mere fact that certain measures are recited in mutually different dependent claims does not indicate that a combination of these measures cannot be used to advantage.

## Claims

1. Surge protection device (200) comprising a semiconductor substrate (210) of a first conductivity type, said semiconductor substrate having a first surface and a second surface opposite to the first surface, the substrate further comprising a first junction device at the first surface, and a second junction device at the second surface, with the first and second junction being separated by the bulk of the semiconductor substrate, wherein the first and second junction devices have been arranged such that said junction devices generate an electrical field extending between the first and second surface of the semiconductor substrate upon exposure to a surge pulse.

2. The surge protection device of claim 1, wherein each junction device is arranged to generate approximately half of said electric field.

3. The surge protection device (200) as claimed in claim 1 or 2, wherein the junction of the first junction device comprises first (202) and second (204) impurity regions of opposite conductivity types diffused into the first surface.

4. The surge protection device (200) of any of claims 1-3, wherein the junction of the second junction device comprises third (212) and fourth (214) impurity regions of opposite conductivity types diffused into the second surface.

5. The surge protection device (200) as claimed in claim 4, wherein the second (204) and fourth (214) impurity regions are separated by the bulk of the semiconductor substrate (210), the second and fourth impurity regions being of a conductivity type opposite to the first conductivity type.

6. The surge protection device (200) of claim 1, wherein at least one of the first and second junction devices comprises a Schottky diode.

7. The surge protection device (200) of any of claims 1-5, wherein the first junction device comprises a bipolar transistor with the first impurity region (202) defining its emitter and the second impurity region (204) defining its base, the surge protection device further comprising:
a bulk contact (206) diffused into the first surface, said bulk contact being separated from the base of the bipolar transistor by a portion of the bulk of the semiconductor substrate (210); and
a metal portion (225) at the first surface connecting the bulk contact with the base.

8. The surge protection device (200) of any of the preceding claims, wherein the semiconductor substrate (210) is a silicon substrate.

9. The surge protection device (200) of any of claims 1-5, wherein at least one of the first surface and second surface carries a metal connection (220, 230) to the corresponding junction device, wherein said metal has a heat conductivity exceeding a predefined threshold.

10. The surge protection device (200) of any of the preceding claims, further comprising a first further junction device at the first surface having a junction oriented parallel to the first surface, said first further junction device being laterally displaced to the first junction device; and
a second further junction device at the second surface having a junction oriented parallel to the second surface, said second further junction device being laterally displaced to the second junction device, with said further junctions being separated by the bulk of the semiconductor substrate.

11. An apparatus comprising the surge protection device (200) of any of claims 1-10.

12. The apparatus of claim 11, further comprising a first lead frame (130) and a second lead frame (120), wherein the second surface of the surge protection device (200) is mounted onto the second lead frame such that the second junction device is directly connected to the second lead frame and wherein the first junction device is electrically connected to the first lead frame through a bond wire (110).

13. The apparatus of claim 12, further comprising a third lead frame (140), wherein the surge protection device further comprises a first further junction device laterally displaced with respect to the first junction device, said first further junction device being electrically connected to the third lead frame through a further bond wire (110).

14. The apparatus of claim 12, further comprising a third lead frame (140), wherein the surge protection device further comprises a second further junction device laterally displaced with respect to the second junction device, said second further junction device being directly connected to the third lead frame.
